# EUROPEAN PATENT APPLICATION

(11) **EP 4 775 717 A1**
(43) Date of publication of application: **15.07.2026**
(21) Application number: 25224688.9
(22) Date of filing: 17.12.2025
(51) Int. Cl.: C30B 11/00, B22D 27/04, C30B 29/52

(54) **GAS COLLECTOR MODULE AND METHOD OF REPLACING THE GAS COLLECTOR IN THE FURNACE**

(30) Priority: 10.01.2025 PL 45093225
(71) Applicant: Seco/Warwick S.A., 66-200 Swiebodzin (PL)
(72) Inventor: Lisiewicz, Marcin, 66-100 Brzezie k. Sulechowa (PL); Wiechczynski, Artur, 66-200 Swiebodzin (PL); Semanicki, Jacek, 64-320 Buk (PL); Piechowicz, Lukasz, 66-200 Swiebodzin (PL)
(74) Representative: Gornicki, Pawel

(57) **Abstract**

The subject of the invention is a gas collector module comprising a thermally insulating partition (2) disposed upon an annular gas collector (3) equipped with nozzles, which is situated on a collector support (4) coupled to a mould feed drive (5) at the elevation of a crystallizer (14), wherein the circumference of the annular gas collector (3) with nozzles features at least four evenly and symmetrically arranged positioning holes (12) designed to receive positioning gas tubes (9) which constitute an integral part of a locking mechanism (13).

## Description

The present invention relates to a gas collector module designed for use in a single-crystal furnace equipped with gas cooling.

Furthermore, the invention encompasses a method for replacing the gas collector within the furnace chamber. This method is specifically intended for the production of castings characterised by either a directional or a single-crystal structure.

The invention is applicable to Vacuum Induction Melting (VIM) furnaces utilising JetCaster technology, as distinguished from traditional Bridgman technology. It is intended specifically for the manufacture of turbofan motor blades characterised by a single-crystal or single-axis structure.

Polish patent description PL242831B1 discloses an apparatus for the production of castings with a directional or single-crystal structure, comprising at least one thermally insulating partition and a cooling chamber featuring a housing and mounted permanently to the perimeter of this housing, directly beneath the insulating partition, is an annular gas collector equipped with gas ejectors that deliver inert gas streams at flow rates modulated by flow regulators. The gas ejector nozzles are oriented toward the centre of the cooling zone. The gas collector, integrated with these nozzles, is permanently installed in the upper region of the cooling zone, situated directly beneath the thermal insulation partition.

The furnace also includes a second vacuum chamber, designated as the mould chamber, which houses the mould feed drive along with the crystallizer that supports the casting mould and the thermally insulating partition. The entire assembly is capable of vertically upward and downward via the mould feed drive." When the mould and the thermal insulation partition reach the upper position, retaining pins extend to secure the partition in place.

Following the pouring of liquid metal from the crucible into the mould, the mould feed drive translates the mould downward while the thermal insulation partition remains secured at the top. Simultaneously, cooling gas is supplied to the mould via the gas installation, routed through the gas collector and discharged by the gas ejectors.

The thermal insulation partition is secured in its upper position by means of locking pins. The collector is supplied with gas through gas piping that is permanently connected to the collector and integrated with the primary gas supply lines.

Existing solutions utilise a configuration where the gas collector and its associated gas nozzles are permanently installed beneath the thermal barrier in the upper section of the cooling zone, serving as an integral component of the cooling zone, commonly referred to as the cooling coil. The gas supply system is permanently connected to the gas collector. Modifications to the mould geometry necessitate adjustments to the collector nozzle configuration, including the number of nozzles and their angular orientation. Furthermore, when utilising a mould with a reduced diameter, nozzle extensions must be employed; due to the effective range of the gas stream, the distance between the nozzle and the mould should be maintained within 20-30 mm.

This design precludes the automatic replacement of the thermal insulation partition, as collisions occur between the partition and the gas nozzles during the transport of the partition within the furnace interior. The collector remains stationary, with the gas supply delivered via tubing permanently mounted to the collector body. Furthermore, adjusting the nozzles within the furnace to correspond with the mould geometry is difficult due to the severe spatial constraints of the furnace interior. This creates an unergonomic and hazardous working environment; the partition is situated at a height of approximately 2.3 metres, requiring the operator to work with their hands overhead in an area lacking internal lighting. The current state-of-the-art design necessitates interrupting the melting process and purging the entire furnace volume, including the melting chamber, following every modification to the mould geometry and this requirement results in extensive operational downtime and significantly reduces furnace productivity.

The essence of the invention is characterised in that the gas collector module comprises a thermally insulating partition situated upon an annular gas collector equipped with nozzles positioned on a collector support and mounted on the mould feed drive at the elevations of the crystallizer, wherein the circumference of the annular gas collector features at least four positioning holes, distributed evenly and symmetrically, designed to receive positioning gas tubes which serve as an integral part of the locking mechanism.

In a preferred embodiment, the positioning gas tubes integrated into the locking mechanism also serve as the primary gas connections.

The essence of the invention further encompasses a method for replacing the gas collector, characterised in that following the completion of the mould cooling cycle, the mould feed drive, operating without a mould, ascends vertically alongside the empty collector support and this movement continues until the assembly reaches the upper position, at which point the collector support makes direct contact with the gas collector. The positioning gas tubes then retract, sliding out of the positioning holes located in the gas collector. This action successfully disengages and releases both the gas collector and the thermal insulation partition. The mould feed drive, the gas collector with integrated nozzles, and the thermal insulation partition translate downward as a single unit. Following the aeration of the mould chamber only, the gas collector and the thermal insulation partition are retracted from the furnace.

The present invention is advantageous in that the gas collector module design facilitates the precise adjustment of its geometry and nozzle alignment relative to the specific dimensions of the poured moulds. Adjustments can be made at any time outside the furnace, for example on a workbench. The architecture of the module enables the interchangeability of various gas collectors or, alternatively, the adjustment of nozzles within a specific collector to suit distinct mould geometries. Such replacements or adjustments are performed without requiring a furnace vent cycle, thereby ensuring continuous operation and the elimination of associated downtime.

The module, in integration with the automated furnace assembly mechanism and the gas supply system, is configured for high-volume industrial serial production.

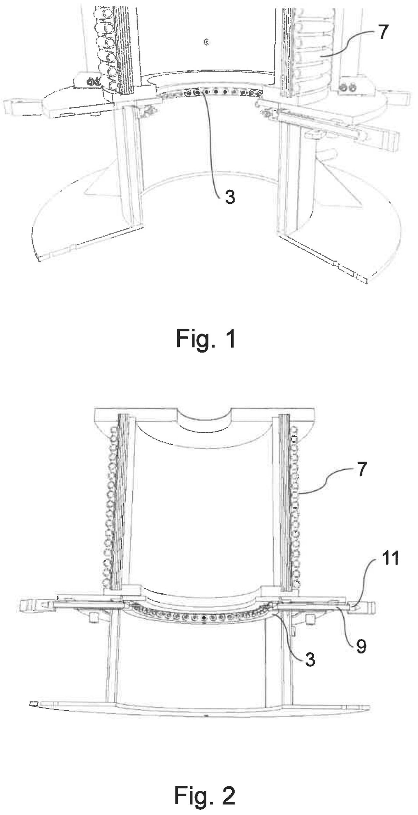

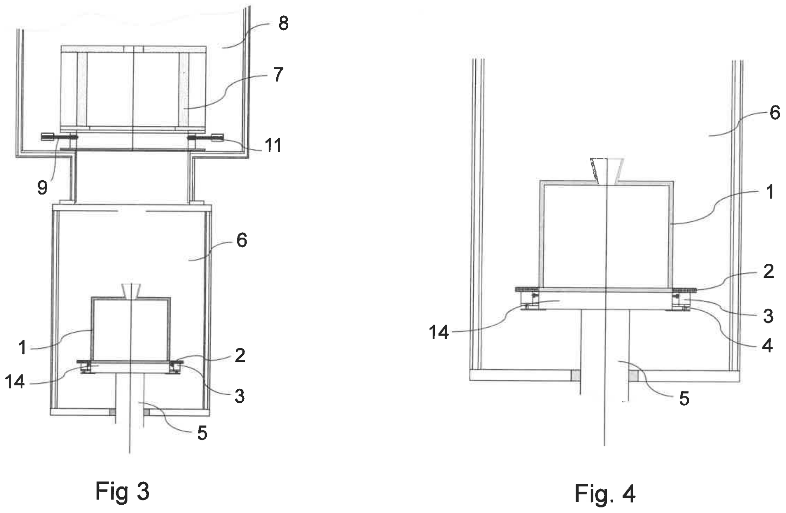

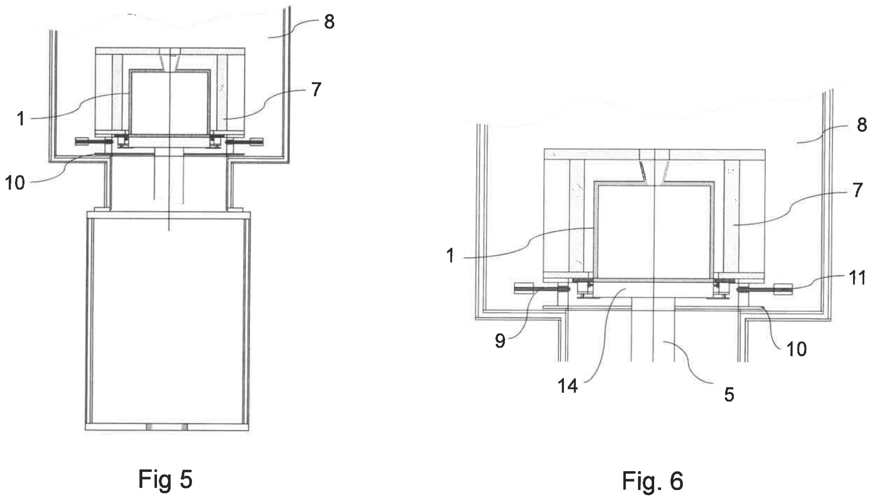

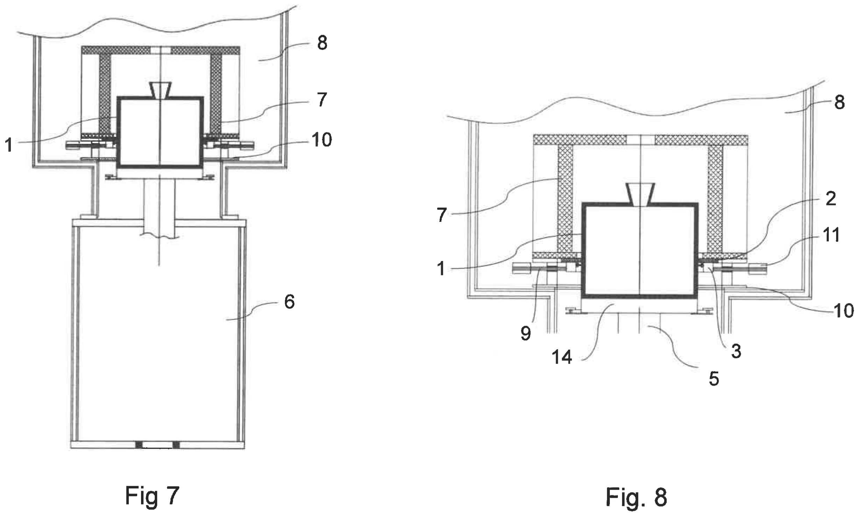

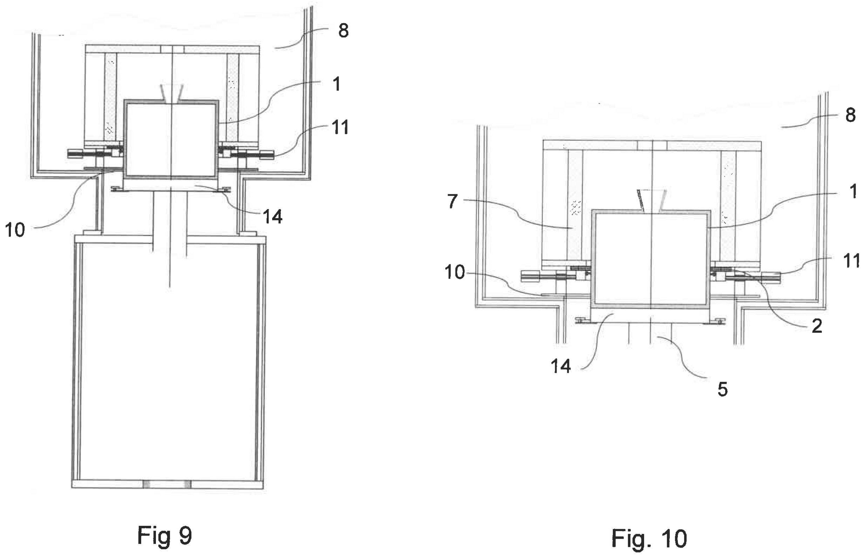

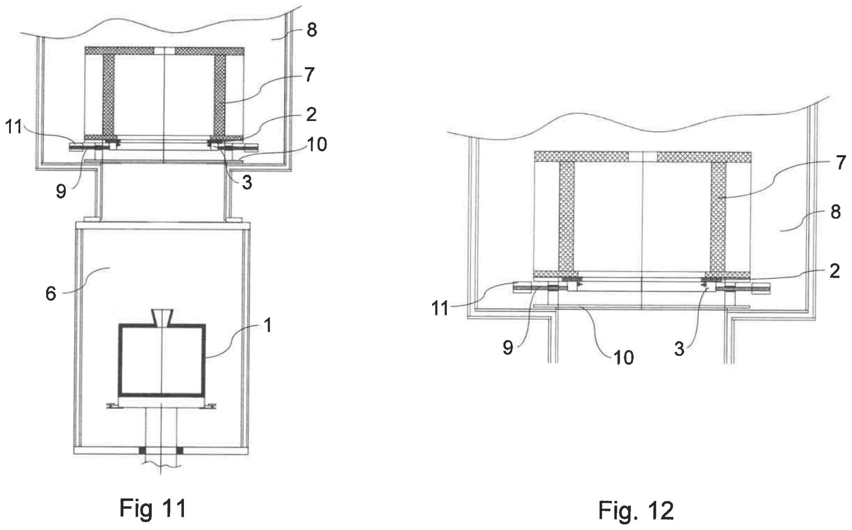

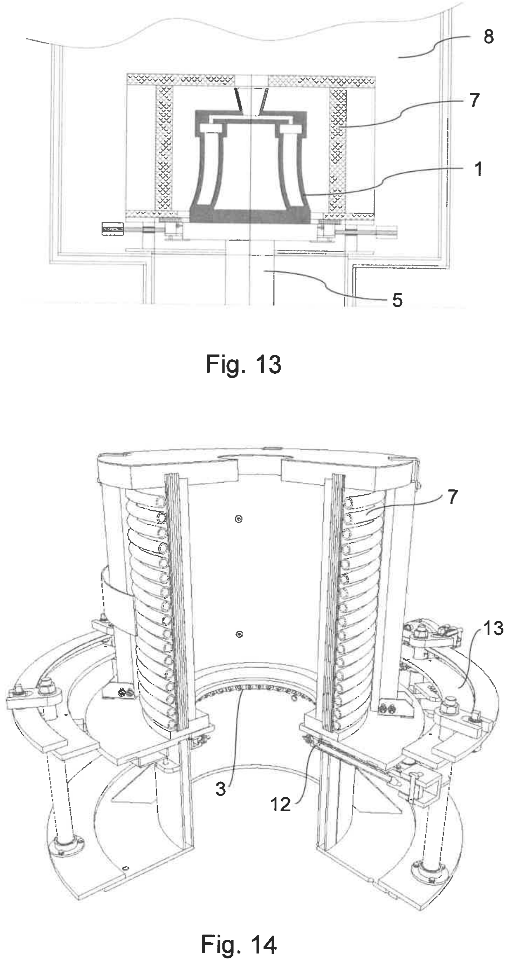

The invention is described by way of embodiments and the accompanying drawings, in which Fig. 1 shows a perspective view of a cross-section of a portion of a mould heater featuring a gas collector and nozzles; Fig. 2 shows a front view of a cross-section of a portion of the mould heater with the gas collector and nozzles; Fig. 3 shows a cross-section of the interconnected mould and melting chambers with the mould in the lower position and the positioning gas tubes in the open position, illustrating the start of the process prior to mould pouring; Fig. 4 shows a detailed view of the mould chamber as depicted in Fig. 3; Fig. 5 shows a cross-section of the interconnected mould and melting chambers with the mould in the upper position and the positioning gas tubes in the open position, illustrating the stage immediately preceding mould pouring; Fig. 6 shows a detailed view of the melting chamber as depicted in Fig. 5; Fig. 7 shows a cross-section of the interconnected mould and melting chambers with the mould in the upper position and the positioning gas tubes in the closed position on the collector, illustrating the initiation of the cooling process; Fig. 8 shows a detailed view of the melting chamber as depicted in Fig. 7; Fig. 9 shows a cross-section of the interconnected mould and melting chambers with the mould in the intermediate position and the positioning gas tubes in the closed position on the collector, illustrating the cooling process during egress from the crystallizer; Fig. 10 shows a detailed view of the melting chamber as depicted in Fig. 9; Fig. 11 shows a cross-section of the interconnected mould and melting chambers with the mould in the lower position and the positioning gas tubes in the closed position on the collector, illustrating the conclusion of the cooling process; Fig. 12 shows a detailed view of the melting chamber as depicted in Fig. 11; Fig. 13 shows a cross-section of the melting chamber during the cooling process for a mould configured for a workpiece in the form of a turbine blade with variable geometry; and Fig. 14 shows a perspective view of a cross-section of a portion of the mould heater with the gas collector and nozzles, revealing a locking mechanism for the positioning gas tubes.

### Embodiment:

A furnace for the production of castings with a directional or single-crystal grain structure comprises a vacuum chamber housing a crucible, wherein the crucible is configured for melting the alloy and pouring the resultant melt into a ceramic mould. The vacuum chamber comprises a heating zone equipped with a mould heater 7 and a cooling zone. The cooling zone includes a cooled housing configured as a cooling ring 10 and is situated directly beneath the heating zone. The furnace further comprises a secondary vacuum chamber, designated as the mould chamber 6, which houses a mould feed drive 5 and an associated crystallizer 14 upon which the casting mould 1 is positioned. The mould feed drive 5 further comprises a collector support 4 mounted at the level of the crystallizer 14; a gas collector 3 equipped with gas nozzles is disposed upon the collector support 4, and a thermal insulation partition 2 is positioned atop said gas collector (Fig. 3).

The entire assembly is capable of vertically upward and downward via the mould feed drive 5 equipped with a servo drive. The gas ejector nozzles are oriented toward the centre of the cooling zone. The mould chamber 6, housing the mould 1 positioned on the crystallizer 14, is sealably closed via a door, whereupon the automatic evacuation of the furnace is initiated by the vacuum pumps. Upon reaching the predetermined vacuum setpoint within the mould chamber 6, the flap valve separating the two chambers opens; subsequently, the mould feed drive 5, together with the gas collector 3 and its nozzles, the thermal insulation partition 2, and the mould 1, translates upward to the pouring-ready position, as illustrated in Fig. 5.

In this position, the locking mechanism 13 is activated to simultaneously extend four locking pins, configured as positioning gas tubes 9, into corresponding horizontal positioning holes 12 and these holes are arranged circumferentially at 90-degree intervals on the gas collector 3, thereby securing the gas collector 3 and the thermal insulation partition 2 in this fixed position (Fig. 7). The locking pins, configured as positioning gas tubes 9, serve a dual purpose by simultaneously functioning as the gas supply conduits for the nozzle-equipped gas collector 3.

After the liquid metal is poured from the crucible into the mould 1, the mould feed drive 5 and the mould 1 descend, whereas the gas collector 3 with nozzles and the thermal insulation partition 2 are retained at the top. Concurrently, cooling gas is delivered to the mould 1 through the positioning gas tubes 9 and then through the gas collector 3 nozzles, as illustrated in Fig. 9.

The present invention may be utilised for the processing of components other than those illustrated in the representative embodiments 1 and 3 in Figures 9 and 10. Fig. 13 shows a cross-sectional view of the melting chamber during crystallization for a mould shaped according to another variant; specifically, for a turbine blade component with variable geometry consisting of a mounting portion and a blade airfoil.

The collector module is configured for automated replacement of the collector 3 or its nozzles, eliminating the need for operator access to the interior of the melting chamber 8. By executing this replacement without breaking the vacuum (airing), the system prevents thermal loss and maintains a consistent production cycle. The collector 3 is advanced to its designated position and fixed by the positioning gas tubes 9.

Upon conclusion of the mould cooling cycle, the mould feed drive 5 without the mould and the vacant collector support 4 move vertically to the upper position, such that the collector support 4 makes contact with the gas collector 3. The positioning gas tubes 9 then retract, sliding out of the positioning holes 12 located in the gas collector 3. This action successfully disengages and releases both the gas collector 3 and the thermal insulation partition 2. The mould feed drive 5, the gas collector 3 with integrated nozzles, and the thermal insulation partition 2 translate downward as a single unit. Following the venting of only the mould chamber to atmospheric pressure, the operator removes the gas collector and the thermal insulation partition from the furnace assembly.

### List of symbols:

1 - mould
2 - thermal insulating partition
3 - gas manifold with nozzles
4 - the manifold support
5 - mould feed drive
6 - mould chamber
7 - mould heater
8 - melting chamber
9 - positioning gas tube
10 - cooling ring
11 - gas connections
12 - positioning holes
13 - locking mechanism
14 - locking mechanism

## Claims

1. A gas collector module comprising an annular gas collector, **characterised in that** it comprises a thermally insulating partition (2) disposed upon an annular gas collector (3) equipped with nozzles, which is situated on a collector support (4) coupled to a mould feed drive (5) at the elevation of a crystallizer (14), wherein the circumference of the annular gas collector (3) with nozzles features at least four evenly and symmetrically arranged positioning holes (12) designed to receive positioning gas tubes (9) which constitute an integral part of a locking mechanism (13).

2. The gas collector module according to claim 1, **characterised in that** the positioning gas tubes (9) incorporated into the locking mechanism (13) simultaneously constitute gas connections (11).

3. A method of replacing a gas collector **characterised in that,** after the mould cooling process is completed, the mould feed drive (5) without the mould, carrying the empty collector support (4) translates vertically to the upper position where the collector support (4) makes contact with the gas collector (3); then, the positioning gas tubes (9), actuated by the locking mechanism (13), retract and slide out of the positioning holes (12) of the gas collector (3), thereby releasing the gas collector (3) and the thermal insulation barrier (2), while the mould feed drive (5), together with the nozzle-equipped gas collector (3) and the thermal insulation barrier (2), moves downward, after which only the mould chamber (6) is vented to atmosphere, and the gas collector (3) and the thermal insulation barrier (2) are removed from the furnace.
